# EUROPÄISCHE PATENTANMELDUNG

(11) **EP 3 703 232 A1**
(43) Veröffentlichungstag der Anmeldung: **02.09.2020**
(21) Anmeldenummer: 20151126.8
(22) Anmeldetag: 10.01.2020
(51) Int. Cl.: H02M 1/32, G01R 19/14, H01R 13/641, H01R 13/66, H02J 7/00, H01M 6/50

(54) **ELEKTRISCHES VERSORGUNGSSYSTEM SOWIE VERFAHREN ZUM BETREIBEN DESSELBEN**

(30) Priorität: 01.03.2019 DE 102019105226
(71) Anmelder: Insta GmbH, 58509 Lüdenscheid (DE)
(72) Erfinder: Grosch, Volker, 45549 Sprockhövel (DE); Wüller, Stefan, 58553 Halver (DE); Hopp, Christian, 44139 Dortmund (DE)

(57) **Zusammenfassung**

Ein elektrisches Versorgungssystem 1 umfasst einen eine mechanische und eine elektrische Schnittstelle 2 aufweisenden Wandler 3. Der Wandler 3 dient zum Bereitstellen einer Konstantspannungsversorgung. Das elektrische Versorgungssystem 1 umfasst desweiteren ein zumindest einen elektrischen Verbraucher 4 aufweisendes Verbrauchermodul 5. Der Wandler 3 und das Verbrauchermodul 5 verfügen über einen ersten und einen zweiten Spannungsversorgungkontakt 7 - 7.3, welche verbrauchermodulseitigen Spannungsversorgungskontakte 7.2, 7.3 mit denjenigen des Wandlers 3 lösbar verbindbar sind und welche wandlerseitigen Spannungsversorgungskontakte 7, 7.1 an eine Versorgungsleitung 6, 6.1 angeschlossen sind. Wandlerseitig ist in zumindest eine der beiden Versorgungsleitungen 6, 6.1 ein im nicht betätigten Zustand in Offen-Stellung befindliches Schaltelement 8 eingeschaltet. Der Wandler 3 verfügt über einen Sensor 9 zum Detektieren, ob ein für einen Betrieb mit diesem Wandler 3 zulässiges Verbrauchermodul 5 bestimmungsgemäß an seine Schnittstelle 2 angeschlossen ist, wobei der Sensor 9 bei einem bestimmungsgemäß an den Wandler 3 angeschlossenen, zulässigen Verbrauchermodul 5 mittel- oder unmittelbar das zumindest eine Schaltelement 8 in seine Geschlossen-Stellung bringt.

Beschrieben ist des Weiteren ein Verfahren zum Betreiben eines solchen elektrischen Versorgungssystems 1.

## Beschreibung

Die Erfindung betrifft ein elektrisches Versorgungssystem mit einem eine mechanische und eine elektrische Schnittstelle aufweisenden Wandler zum Bereitstellen einer Konstantspannungsversorgung und mit einem daran anschließbaren, zumindest einen elektrischen Verbraucher aufweisenden Verbrauchermodul, wobei der Wandler und das Verbrauchermodul einen ersten und einen zweiten Spannungsversorgungkontakt umfassen, welche verbrauchermodulseitigen Spannungsversorgungskontakte des Verbrauchermoduls mit denjenigen des Wandlers lösbar verbindbar sind und welche wandlerseitigen Spannungsversorgungskontakte an eine Versorgungsleitung angeschlossen sind. Ferner betrifft die Erfindung ein Verfahren zum Betreiben eines solchen elektrischen Versorgungssystems.

Die elektrische Energieversorgung von nicht fest installierten elektrischen Verbrauchern erfolgt typischerweise über den Anschluss eines elektrischen Verbrauchers an eine an das öffentliche Stromversorgungsnetz angeschlossene Steckdose als elektrische und mechanische Schnittstelle zwischen dem Stromversorgungsnetz und einem daran anzuschließenden elektrischen Verbraucher. Andere Stromversorgungssysteme dienen zur Stromversorgung von elektrischen Verbrauchern und liefern an ihren diesbezüglichen Schnittstellen eine Konstantspannung, beispielsweise 12V oder 24V. Eingesetzt werden hierfür Wandler, die die 230V-Wechselspannung des öffentlichen Netzes in die für den Betrieb eines spezifischen elektrischen Verbrauchers benötigte Niedervolt-Gleichspannung wandeln. Aus Sicherheitsgründen sind bei derartigen Wandlern Mechanismen vorgesehen, die einen Betrieb des Wandlers ausschließlich im Bereich eines bestimmten Spannungs-Strom-Bereiches zulassen. Zu diesem Zweck werden spezielle Arbeitspunkte definiert, um einen hinreichenden Schutz vor Überlastung des Wandlers zu gewährleisten. Dieses betrifft nicht lediglich die mittlere Leistungsaufnahme durch den an den Wandler angeschlossenen Verbraucher, sondern auch die Leistungsaufnahme während eines Schaltvorganges, weshalb auch zeitabhängige Bereiche definiert werden, um etwa Durchbruchseffekte in Transistoren zu vermeiden. Durch diese Maßnahmen wird grundsätzlich ein hinreichender Schutz vor einem elektrischen Fehlbetrieb des Wandlers erreicht. Nicht unproblematisch ist mitunter ein Betriebsfall, der zwar aus elektrischer Sicht unbedenklich ist, also in dem zugelassenen Spannungs-Strom-Bereich liegt, der aber durch die Art der an den Wandler angeschlossenen Last dennoch einen Fehllastbetrieb darstellt. Eine derartige Betriebssituation könnte durch Einführen von elektrisch leitenden Gebrauchsutensilien, wie etwa Essbesteck, Nadeln oder Kinderspielzeug in die elektrische Schnittstelle des Wandlers, beispielsweise durch Kinder entstehen. Eine solche Betriebssituation kann sich auch einstellen, wenn die Schnittstelle des Wandlers mit metallischer Scheuerwolle gereinigt wird und hierbei der stromführende Versorgungsspannungskontakt des Wandlers kontaktiert wird.

Aus dem Stand der Technik sind zur Sicherung von Steckdosen als Spannungsversorgungsschnittstellen gegen unsachgemäßen Betrieb durch Kinder mechanische Kindersicherungen bekannt, bei denen die Steckdose entweder durch Abdeckklappen gesichert ist oder - im Falle von offenen Steckdosen - die Spannungskontakte durch mechanische Verriegelungsmechanismen, die es zur Nutzung der Schnittstelle erst zu überwinden gilt, blockiert sind. Derartige Sicherungen sind verbreitet, jedoch mitunter schwierig bzw. umständlich zu betätigen. Eine Überwindung des Verriegelungsmechanismus erfolgt mit den Steckkontakten eines Steckers, beispielsweise dadurch, dass die eine die Einstecköffnung verblendende Sicherungsscheibe in ihre Freigabestellung gedreht werden muss, bevor die Steckkontakte mit den komplementären Steckbuchsenkontakten der Steckdose in Eingriff gestellt werden können.

Auch sind über eine Fernbedienung betätigbare Wandler und Steckdosen bekannt, bei denen die elektrische Versorgung des angeschlossenen Verbrauchers erst dann freigegeben wird, wenn nutzerseitig ein entsprechender Befehl abgesetzt worden ist. Eine hinreichende Sicherung zur Vermeidung von den vorbeschriebenen unzulässigen Betriebssituationen kann, da die Anschlusskontakte zugänglich sind, nicht wirksam vermieden werden. Hierzu bedürfte es eines zusätzlichen Einsatzes einer mechanischen Sicherung, beispielsweise wie vorbeschrieben.

Ausgehend von dem diskutierten Stand der Technik liegt der Erfindung daher die Aufgabe zu Grunde, ein elektrisches Versorgungssystem mit einem Wandler und mit einem daran lösbar anschließbaren Verbrauchermodul bereitzustellen, bei dem gewährleistet ist, dass sich auch die vorbeschriebenen, nicht zulässigen Betriebssituationen nicht einstellen können.

Diese Aufgabe wird erfindungsgemäß durch ein eingangs genanntes elektrisches Versorgungssystem gelöst, bei dem wandlerseitig in zumindest eine der beiden Versorgungsleitungen ein im nicht betätigten Zustand in Offen-Stellung befindliches Schaltelement eingeschaltet ist und der Wandler über einen Sensor zum Detektieren verfügt, ob ein für einen Betrieb mit diesem Wandler zulässiges Verbrauchermodul bestimmungsgemäß an seine Schnittstelle angeschlossen ist, wobei der Sensor bei einem bestimmungsgemäß an den Wandler angeschlossenen, zulässigen Verbrauchermodul mittel- oder unmittelbar das zumindest eine Schaltelement in seine Geschlossen-Stellung bringt.

Bei diesem elektrischen Versorgungssystem wird das elektrische Verbrauchermodul mit seinem zumindest einen elektrischen Verbraucher durch einen Wandler, der über eine Gleichspannungsquelle - beispielsweise eine Batterie oder eine gleichgerichtete Wechselspannung - verfügt, mit Konstantspannung versorgt. Der Wandler weist eine Schnittstelle auf, an die das Verbrauchermodul anzuschließen bzw. angeschlossen ist. Der Anschluss des Verbrauchermoduls ist lösbar ausgelegt, damit unterschiedliche Verbrauchermodule an die Schnittstelle angeschlossen werden können. Zum Betrieb des über die Schnittstelle an den Wandler angeschlossenen Verbrauchermoduls ist dieses durch den Wandler konstantspannungsversorgt. Die beiden Versorgungsleitungen des Wandlers sind an eine Stromversorgung angeschlossen. In wenigstens eine dieser beiden Versorgungsleitungen ist ein Schaltelement eingeschaltet. Dieses befindet sich, wenn nicht betätigt, in seiner Offen-Stellung. Damit ist die Schnittstelle des elektrischen Versorgungssystems grundsätzlich spannungslos. Geschaltet wird das zumindest eine Schaltelement unmittelbar durch oder mittelbar über einen dem Wandler zugehörigen Sensor. Dieser dient zum Detektieren, ob ein für einen Betrieb mit diesem Wandler zulässiges Verbrauchermodul bestimmungsgemäß an die Schnittstelle des Wandlers angeschlossen ist. Der Sensor detektiert somit, ob es sich bei dem angeschlossenen Verbrauchermodul mit seinem einen oder mehreren Verbrauchern um ein zum Anschluss an den Wandler zulässiges Verbrauchermodul handelt und ob dieses bestimmungsgemäß an den Wandler angeschlossen ist. In Abhängigkeit von dem Detektionsergebnis des Sensors und zwar dann, wenn der Sensor den bestimmungsgemäßen Anschluss eines zugelassenen Verbrauchermoduls detektiert hat, bringt dieser das zumindest eine Schaltelement in seine Geschlossen-Stellung und stellt damit die Konstantspannungsversorgung des Verbrauchermoduls mit seinem zumindest einen elektrischen Verbraucher her. Anderenfalls verbleibt das in die zumindest eine der beiden Versorgungsleitungen eingeschaltete Schaltelement in seiner Offen-Stellung. Der Stromfluss zu dem an diese Versorgungsleitung angeschlossenen Spannungsversorgungskontakt bleibt damit unterbunden. Das Schaltelement wird man typischerweise in die stromführende Versorgungsleitung einschalten. Durch diese Maßnahme liegt an dem an diese Versorgungsleitung angeschlossenen Spannungsversorgungskontakt nur dann Spannung an, wenn durch das an den Wandler mechanisch angeschlossene Verbrauchermodul bestimmungsgemäß montiert und damit auch die Spannungsversorgungskontakte nicht mehr zugänglich sind. Eine unsachgemäße Betriebssituation, wie beispielsweise durch Einführen von elektrisch leitenden Gebrauchs- oder Spielutensilien in eine Steckeraufnahme, sollte eine derartige vorgesehen sein, oder die Berührung eines freiliegenden Spannungsversorgungskontaktes, da stromlos, stellt bei diesem Wandler keine Gefährdung dar. Strom- bzw. spannungsbeaufschlagt sind die Spannungsversorgungskontakte nur, wenn ein zulässiges Verbrauchermodul bestimmungsgemäß an den Wandler angeschlossen ist.

Der Sensor zum Detektieren eines bestimmungsgemäßen Anschlusses eines zulässigen Verbrauchermoduls an den Wandler kann unterschiedlich arbeitend ausgelegt sein. Die Kodierung für die Detektion zwischen Wandler und Verbrauchermodul kann beispielsweise mechanisch, magnetisch, mittels RFID optisch oder auch elektrisch ausgelegt sein. Auch eine Kombination von verschiedenen Maßnahmen ist möglich.

Im Falle einer mechanischen Kodierung einer Sensorbetätigung ist gemäß einer Ausgestaltung der Sensor als Tastsensor ausgelegt und im Bereich der Schnittstelle des Wandlers derart angeordnet, dass dieser sich nicht ohne Weiteres betätigen lässt. Eine andere Art der Kodierung einer bestimmungsgemäßen Sensorbetätigung kann magnetisch erfolgen. Der Sensor wird bei einer solchen Auslegung dann durch einen dem Verbrauchermodul zugeordneten Betätigungsmagneten betätigt. Eine solche Sensorbetätigung kann durch die abstoßende Kraft zweier Magnete oder durch eine Anzugskraft zweier Magnete oder auch durch einen Magneten hervorgerufen werden. Wird nur ein Magnet eingesetzt, handelt es sich bei dem Gegenstück um ein Bauteil mit ferromagnetischen Eigenschaften. Der Betätigungsmagnet wird typischerweise dem Verbrauchermodul zugeordnet sein, damit eine Sensorbetätigung nicht bereits dann erfolgt, wenn an die Schnittstelle ein ferromagnetisches Metallstück gehalten wird.

Eine optische Kodierung kann beispielsweise durch das Lesen eines auf dem Verbrauchermodul befindlichen Barcodes durch den Sensor realisiert sein. Ebenfalls ist eine optische Kodierung möglich, bei der das Verbrauchermodul Licht einer bestimmten Wellenlänge aussendet oder reflektiert, welches durch den Sensor erfasst wird und das Schaltelement nur für den Fall einer von dem Sensor empfangenen zugelassenen Wellenlänge in seine Geschlossen-Stellung gebracht wird.

Bei dem Sensor kann es sich um das bewegliche Teil des in die Stromversorgungsleitung eingeschalteten Schaltelementes handeln. Dann erfolgt ein Schalten dieser Versorgungsleitung unmittelbar durch den Sensor, und zwar ohne Zwischenschaltung einer Steuereinheit, etwa eines Microcontrollers. Gemäß einer anderen Ausgestaltung ist der Sensor an einen Auswerteeingang einer Steuereinheit angeschlossen, die das Sensorsignal auswertet und in Abhängigkeit von dem empfangenen Sensorsignal das Schaltelement entsprechend ansteuert, wenn sich aus dem empfangenen Sensorsignal ergibt, dass das in die Versorgungsleitung eingeschaltete Schaltelement geschlossen werden soll. Das Sensorsignal kann das Signal eines geschlossenen Tasters sein. Ist eine Steuereinheit an einen solchen Sensor angeschlossen, kann die Einschaltinformation auch durch eine bestimmte Sensorbetätigungsfolge kodiert sein.

In aller Regel ist in einem solchen Wandler für den Betrieb des Verbrauchermoduls ohnehin eine als Microcontroller ausgelegte Steuereinheit vorhanden, sodass dessen Ressourcen ohne Weiteres auch für die Realisierung dieses Konzeptes genutzt werden können.

In einer Ausführungsform der Erfindung ist die mechanische Schnittstelle des Wandlers als mechanische Aufnahme nach Art einer Steckdose ausgeführt, in die ein komplementäres, für einen Betrieb mit dem Wandler zulässiges Verbrauchermodul den Sensor betätigendes Gegenstück einzusetzen ist.

Zahlreiche elektrische Versorgungssysteme der in Rede stehenden Art verfügen neben den beiden Spannungsversorgungskontakten zusätzlich über einen Datenübertragungskontakt. Der wandlerseitige Datenübertragungskontakt ist an seine Steuereinheit angeschlossen. Über den Datenübertragungskontakt werden Ansteuerdaten an das Verbrauchermodul übermittelt. Eine solche Datenübertragung kann unidirektional oder auch bidirektional erfolgen. Das Vorhandensein des zusätzlichen Datenkontaktes an der elektrischen Schnittstelle zwischen Wandler und Verbrauchermodul eröffnet die Möglichkeit, auf besonders einfache Weise auch eine elektrische Kodierung bereitzustellen. In einer möglichen Ausführungsform ist zu diesem Zweck der wandlerseitige Datenkontakt an die erste Versorgungsleitung angeschlossen, und zwar unter Einschaltung eines hochohmigen Widerstandes. An einem Knotenpunkt dieser Verbindungsleitung ist die Steuereinheit angeschlossen, wobei der hochohmige Widerstand zwischen diesem Knotenpunkt, an dem die Steuereinheit angeschlossen ist, und dem Datenkontakt vorgesehen ist. In dem ersten Abschnitt dieser Verbindungsleitung, der den Abzweig von der Versorgungsleitung mit dem genannten Knotenpunkt verbindet, ist ebenfalls ein Widerstand eingeschaltet. Der Abzweig dieser Verbindungsleitung befindet sich - von der Spannungsquelle aus betrachtet - vor dem von der Steuereinheit ansteuerbaren Schaltelement. Auf diese Weise kann über den Datenkontakt nur ein geringer Strom geführt werden. Der vorbeschriebene Knotenpunkt hat ebenfalls eine Verbindung zur Masseleitung, wobei in diesen Leitungsabschnitt vorzugweise ebenfalls ein Widerstand eingeschaltet ist. Wenn der Datenkontakt des Wandlers mit seinem zweiten Spannungsversorgungskontakt - dem Massekontakt - verbunden ist, kann die Steuereinheit über den Knotenpunkt die anliegende Spannung erfassen.

Als Komplementär verfügt das Verbrauchermodul über einen seinen Datenkontakt mit seinem Massekontakt verbindenden Widerstand, durch den ein spezifischer Spannungsabfall herbeigeführt wird. Die Größe des Widerstandes und der dadurch bewirkte Spannungsabfall bei an dem Wandler angeschlossenen Verbrauchermodul in dem Knotenpunkt des Wandlers, an den die Steuereinheit angeschlossen ist, stellt somit eine Kodierung desselben dar. Ist das Verbrauchermodul an den Wandler angeschlossen, wird dieser Spannungsabfall durch die an den Knotenpunkt angeschlossene Steuereinheit erfasst. Entspricht der Spannungsabfall dem für ein zulässiges Verbrauchermodul vorgesehenen Spannungsabfall wird durch die Steuereinheit das in die Versorgungsleitung eingeschaltete Schaltelement in seine Geschlossen-Stellung gebracht.

Gemäß einem weiteren Ausführungsbeispiel einer Spannungskodierung des Wandlermoduls dient wandlerseitig ein Spannungsteiler als Sensor. Dieser ist durch zumindest zwei in Reihe geschaltete Widerstände gebildet. Der Spannungsteiler ist zwischen den Versorgungsleitungen des Wandlers aufgespannt und befindet sich vor dem, die Versorgungsspannung an die Schnittstelle schaltenden Schaltelement, sodass dieses auch bei geöffnetem Schaltelement bestromt ist. Dabei ist der Eingang des Spannungsteilers an einen ersten Spannungsversorgungskontakt bzw. die an diesen Spannungsversorgungskontakt angeschlossene Versorgungsleitung und der Ausgang an den zweiten Spannungsversorgungskontakt bzw. die an diesen Spannungsversorgungskontakt angeschlossene Versorgungsleitung angeschlossen. An einen zwischen den Widerständen des Spannungsteilers befindlichen Knotenpunkt ist der Datenübertragungskontakt angeschlossen. Dieser Knotenpunkt ist zugleich an einen Sensoreingang der Steuereinheit des Wandlers angeschlossen. Bei diesem elektrischen Verbrauchersystem verfügt auch das Verbrauchermodul über einen Spannungsteiler mit zumindest zwei in Reihe geschalteten Widerständen. Dieser ist ebenfalls zwischen den beiden Spannungsversorgungskontakten aufgespannt. Auch zwischen den Widerständen dieses Spannungsteilers befindet sich ein Knotenpunkt, der an den Datenübertragungskontakt des Verbrauchermoduls gelegt ist. Die beiden Spannungsteiler sind unterschiedlich aufgebaut, sodass die in dem jeweiligen Knotenpunkt abgegriffene Spannung sich voneinander unterscheidet. Durch die Auslegung der Spannungsteiler erfolgt bei dieser Realisierung die Kodierung zwischen Wandler und Verbrauchermodul. Nur wenn am wandlerseitigen Knotenpunkt und damit am sensorseitigen Eingang der Steuereinheit eine vorbestimmte Spannung bei angeschlossenem Verbrauchermodul abgegriffen wird, wird durch die Steuereinheit das in die Versorgungsleitung eingeschaltete Schaltelement entsprechend angesteuert. Hierzu werden bei diesem Ausführungsbeispiel die Spannungsteiler des Wandlers und des Verbrauchermoduls mit einer Testspannung, die geringer als die Versorgungsspannung ist und lediglich einen geringen Stromfluss verursacht, beaufschlagt. Die Möglichkeiten einer solchen Kodierung sind vielfältig. Grundlage der Auswertung ist, dass durch ein zulässiges und bestimmungsgemäß an den Wandler angeschlossenes Verbrauchermodul die am wandlerseitigen Knotenpunkt abgegriffene Spannung sich von derjenigen unterscheidet, die an diesem Knotenpunkt abgreifbar ist, wenn an die Schnittstelle des Wandlers kein Verbrauchermodul angeschlossen ist. Beeinflusst wird die an dem wandlerseitigen Knotenpunkt abgreifbare Spannung durch den auf diesen Knotenpunkt ebenfalls Einfluss nehmenden Spannungsteiler des Verbrauchermoduls, da über die miteinander in Kontakt stehenden Datenübertragungskontakte der Knotenpunkt des verbrauchermodulseitigen Spannungsteilers auf den Knotenpunkt des wandlerseitigen Spannungsteiler gelegt ist.

Für die gewünschten Detektionszwecke benötigt man nicht die von dem Wandler zum Betreiben der Verbraucher des Verbrauchermoduls erforderliche Spannung. Vielmehr kann man die vorbeschriebene elektrische Zulässigkeitsprüfung in Bezug auf das an den Wandler angeschlossene Verbrauchermodul bereits bei geringen Spannungen und Strömen durchführen. Dieses kann beispielsweise durch einen Bypass, durch den das in eine Versorgungsleitung eingeschaltete Schaltelement überbrückt wird, realisiert sein. In dem Bypass ist bei einer solchen Ausgestaltung ein hochohmiger Widerstand und ein durch die Steuereinheit des Wandlers ansteuerbares Schaltelement integriert. Für die vorbeschriebene elektrische Zulässigkeitsprüfung wird durch die wandlerseitige Steuereinheit das im Bypass befindliche Schaltelement geschlossen, sodass die durch die Spannungsversorgung bereitgestellte Versorgungsspannung durch den hochohmigen Widerstand erheblich reduziert wird; mithin auf diese Weise eine geringere Testspannung zur Durchführung der Zulässigkeitsprüfung bereitgestellt wird. Die hochohmige Versorgungsspannung am Datenübertragungskontakt ist hinreichend, um die Detektion durchzuführen. Erst wenn die Auswertung der an den wandlerseitigen Knotenpunkt des Spannungsteilers anliegenden Spannung einer zuvor als zulässig definierten Spannung oder innerhalb eines zuvor als zulässig definierten Spannungsbereiches liegt, wird über die Steuereinheit das in die Versorgungsleitung eingeschaltete Schaltelement zum Freigeben der Konstantspannungsversorgung angesteuert.

In einer Weiterbildung eines solchen elektrischen Versorgungssystems ist vorgesehen, dass auf den wandlerseitigen Spannungsteiler erst dann eine Spannung für die vorbeschriebene Detektionszwecke gelegt wird, wenn ein Verbrauchermodul an den Wandler angeschlossen ist und die Spannungsversorgungskontakte von außen nicht mehr zugänglich sind. Dieses kann beispielsweise durch einen in der mechanischen Schnittstelle angeordneten Taster erfolgen, der ebenfalls an einen Eingang der Steuereinheit angeschlossen ist.

In einer Weiterbildung der Ausführungsform mit einem Spannungsteiler als Sensor ist zwischen den Knotenpunkten des wandlerseitigen und des verbrauchermodulseitigen Spannungsteilers zumindest ein Widerstand angeordnet - entweder in dem wandlerseitigen oder in dem verbrauchermodulseitigen Spannungsteiler. Hierdurch kann die Belastbarkeit des Datenübertragungssignals bestimmt werden. Zudem kann so die über den Datenkontakt bereitgestellte Energie in dem Maße reduziert werden, dass ein gefährlicher Zustand durch das Einführen von Gegenständen in die Schnittstelle nicht zu einer Gefährdung führen kann. Darüber hinaus bietet der Widerstand wirksamen Schutz gegen elektrostatische Entladungs- und Spannungsspitzen.

Die vorbeschriebene Überprüfung des an den Wandler angeschlossenen Verbrauchermoduls wird man am Ende eines jeden über die Datenübertragungskontakte übertragenen Datenpaketes vorsehen, und zwar indem man am Ende eines jeden Datenpaketes eine definierte Zeitspanne vorsieht, in der für die vorbeschriebene Detektionszwecke die Datenspannung den Maximalwert einnimmt. Diese Spannung stellt sodann die Eingangsspannung für die Spannungsteiler dar. Die durch die Datenschnittstelle bereit gestellte Stromstärke dieser Spannung ist extrem gering.

Bei einer elektrischen Kodierung zwischen Wandler und Verbrauchermodul, wie vorstehend beispielsweise anhand der jeder Einheit zugeordneten Spannungsteiler beschrieben, kann das Detektionsverfahren mehrfach durchgeführt werden, um über eine gewisse Redundanz an Messungen die Auswertegenauigkeit zu erhöhen. Dabei erfolgt die Beaufschlagung des Verbrauchermoduls mit Konstantspannung erst nach Erreichen einer gewissen Anzahl von für das Freischalten vorgegebener Detektionsergebnisse.

In einer Weiterbildung einer Ausführungsform mit einer magnetischen Kodierung zum Durchschalten der Versorgungsspannung ist vorgesehen, dass der Auslösemagnet des Sensors das Gegenstück mit seinem Betätigungsmagneten in bzw. an der Schnittstelle des Wandlers fixiert, mithin die Sensorauslösefunktionalität zugleich zum Halten des Verbrauchermoduls am Wandler genutzt wird.

Nachstehend ist die Erfindung anhand von Ausführungsbeispielen unter Bezugnahme auf die beigefügten Figuren beschrieben. Es zeigen:
- **Fig. 1:**: Ein Blockschaltbild eines elektrischen Versorgungssystems mit einem eine Schnittstelle aufweisenden Wandler und mit einem daran angeschlossenen Verbrauchermodul,
- **Fig. 2:**: ein Blockschaltbild eines weiteren elektrischen Versorgungssystems mit einem eine Schnittstelle aufweisenden Wandler und mit einem daran angeschlossenen Verbrauchermodul,
- **Fig. 3:**: ein Schaltbild eines elektrischen Versorgungssystems mit einem eine Schnittstelle aufweisenden Wandler und mit einem daran angeschlossenen Verbrauchermodul gemäß einem weiteren Ausführungsbeispiel und
- **Fig. 4:**: ein Schaltbild eines weiteren elektrischen Versorgungssystems mit einem eine Schnittstelle aufweisenden Wandler und mit einem daran angeschlossenen Verbrauchermodul.

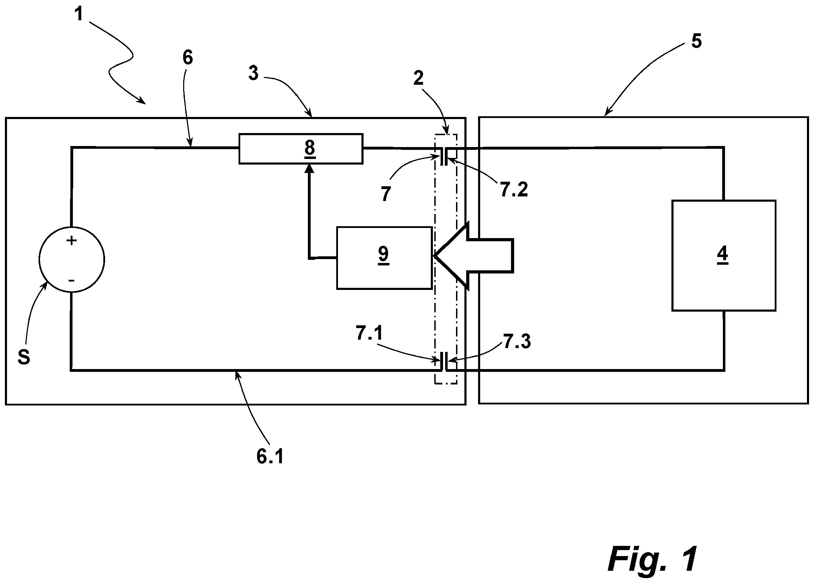

Ein elektrisches Versorgungssystem 1 umfasst ein Wandler 3 und ein elektrisches Verbrauchermodul 5. Das elektrische Verbrauchermodul 5 umfasst einen elektrischen Verbraucher 4. Bei diesem kann es sich beispielsweise um eine Vielzahl von LEDs handeln. Der Wandler 3 verfügt über zwei Spannungsversorgungskontakte 7, 7.1, die ihrerseits jeweils an eine Versorgungsleitung 6, 6.1 einer Spannungsversorgung S angeschlossen sind. Die Spannungsversorgung S liefert bei dem dargestellten Ausführungsbeispiel eine Konstantspannung. Das Verbrauchermodul 5 verfügt ebenfalls über zwei Spannungsversorgungskontakte 7.2, 7.3. Dabei ist vorgesehen, dass der Spannungsversorgungskontakt 7.2 den Spannungsversorgungskontakt 7 des Wandlers 3 und der Spannungsversorgungskontakt 7.3 den Spannungsversorgungskontakt 7.1 des Wandlers 3 kontaktieren. Die Schnittstelle 2 des Wandlers 3 ist in der Figur nur bezüglich seiner elektrischen Bestandteile gezeigt. Die Schnittstelle 2 ist mechanisch so ausgelegt, dass ein Anschluss des Verbrauchermoduls 5 mit umgekehrter Polung als in Figur 1 gezeigt, nicht möglich ist. Das Verbrauchermodul 5 ist an den Wandler 3 über eine Schnittstelle 2 lösbar angeschlossen. Der Wandler 3 verfügt über einen Sensor 9, welcher detektiert, ob ein für einen Betrieb mit diesem Wandler 3 zulässiges Verbrauchermodul 5 bestimmungsgemäß an seine Schnittstelle 2 angeschlossen ist. Bejahendenfalls wird durch diesen ein in der Versorgungsleitung 6 eingeschaltetes elektrisches Schaltelementes 8 in seine Geschlossen-Stellung gebracht. Das Schaltelement 8 befindet sich grundsätzlich in seiner Offen-Stellung, sodass der Spannungsversorgungskontakt 7 nur dann spannungsbeaufschlagt ist, wenn das Schaltelement 8 geschlossen ist. Bei dem dargestellten Ausführungsbeispiel handelt es sich bei dem Sensor 9 um das mechanisch bewegliche Teil eines elektrischen Schalters. Bei dem Schaltelement 8 handelt es sich somit letztendlich um die elektrischen Schaltkontakte. Sensor 9 und Schaltelement 8 sind bei diesem Ausführungsbeispiel eine bauliche Einheit.

Die Schnittstelle 2 des elektrischen Versorgungssystems 1 verfügt neben den in der Figur 1 gezeigten elektrischen Schnittstelle zudem über eine mechanische Schnittstelle, an der das Verbrauchermodul 5 an dem Wandler 3 befestigt werden kann. Hierzu kann die Schnittstelle 2 eine Aufnahme zum Einsetzen eines Gegenstückes des Verbrauchermoduls 5 aufweisen. An einer manuell nicht ohne Weiteres zugänglichen Stelle befindet sich der Sensor 9, auf den das Gegenstück zu seiner Betätigung wirkt.

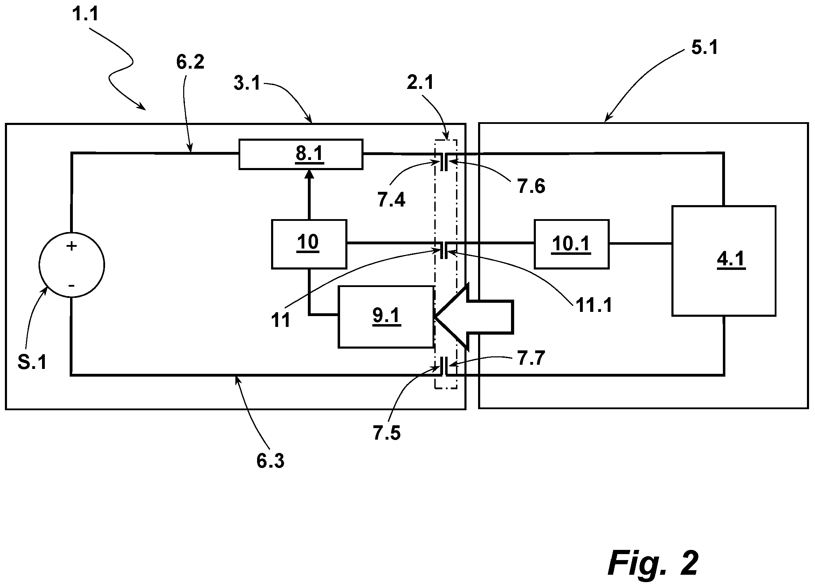

Figur 2 zeigt in einer Weiterbildung ein weiteres elektrisches Versorgungssystem 1.1. Dieses ist prinzipiell aufgebaut wie das elektrische Versorgungssystem 1 des Ausführungsbeispiels der Figur 1. Gleiche Bauteile dieses elektrischen Versorgungssystems 1.1 mit denjenigen des elektrischen Versorgungssystems 1 sind mit gleichen Bezugszeichen kenntlich gemacht, ergänzt um das Suffix ".1" oder einen entsprechend höheren Zähler. Das elektrische Versorgungssystem 1.1 verfügt neben seinen Spannungsversorgungskontakten 7.4, 7.5, 7.6, 7.7 über Datenübertragungskontakte 11, 11.1, wobei ein Datenübertragungskontakt 11 dem Wandler 3.1 und ein Datenübertragungskontakt 11.1 dem Verbrauchermodul 5.1 zugeordnet ist. Der wandlerseitige Datenübertragungskontakt 11 ist an eine Steuereinheit 10, bei dem dargestellten Ausführungsbeispiel als Microcontroller ausgeführt, angeschlossen. Auch das Verbrauchermodul 5.1 verfügt über eine Steuereinheit 10.1, durch die der elektrische Verbraucher 4.1 angesteuert wird. Über die die beiden Steuereinheiten 10, 10.1 verbindende Datenleitung können Daten zum Ansteuern des Verbrauchers 4.1 des Verbrauchermoduls 5.1 übertragen werden, beispielsweise Dimmdaten. Im Zusammenhang mit dem Gegenstand der Erfindung wird die wandlerseitige Steuereinheit 10 genutzt, damit ein Betätigungssignal des Sensors 9.1 einen Sensoreingang der Steuereinheit 10 beaufschlagt. Das bei einer Betätigung des Sensors 9.1 erzeugte Sensorsignal wird durch die Steuereinheit 10 ausgewertet, die dann in Abhängigkeit von dem empfangenen Sensorsignal das Schaltelement 8.1 entsprechend ansteuert. Wird das von der Steuereinheit 10 empfangene Sensorsignal als solches bewertet, dass das an die Schnittstelle 2.1 angeschlossene Verbrauchermodul 5.1 als zulässig und bestimmungsgemäß mit dem Wandler 3.1 verbunden angesehen wird, wird das Schaltelement 8.1 geschlossen, um auf diese Weise die Stromversorgung zu dem Verbrauchermodul 5.1 freizuschalten.

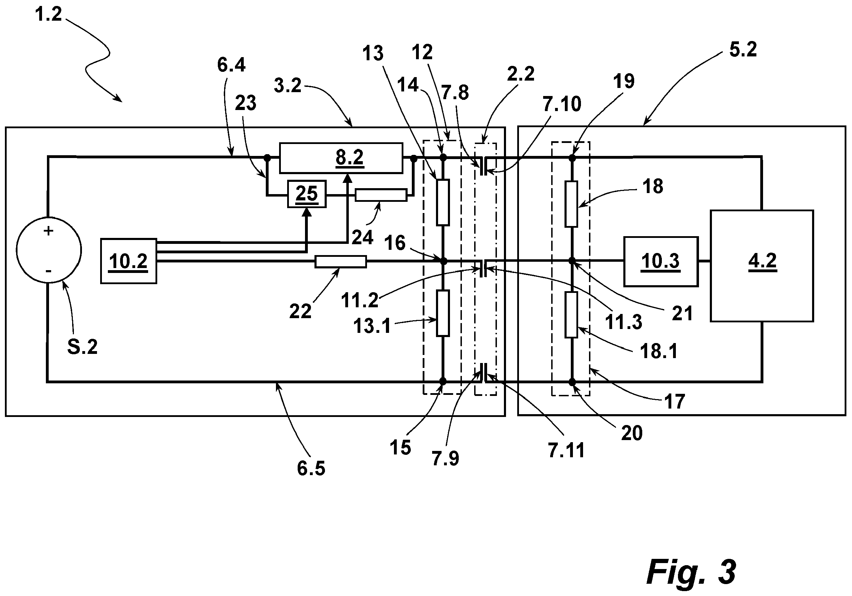

Figur 3 zeigt ein weiteres elektrisches Versorgungssystem 1.2, welches prinzipiell aufgebaut ist wie das elektrische Versorgungssystem 1.1, dessen Sensor, jedoch ausschließlich elektrisch arbeitet. Gleiche Bauteile dieses elektrischen Versorgungssystems 1.2 mit denjenigen des elektrischen Versorgungssystems 1.1 sind mit gleichen Bezugszeichen kenntlich gemacht, ergänzt um das Suffix mit einem entsprechend höheren Zähler. Bei dieser Ausführungsform umfasst der Wandler 3.2 einen Spannungsteiler 12 als Sensor, der aus zwei in Reihe geschalteten Widerständen 13, 13.1 gebildet ist. Der Eingang 14 des Spannungsteilers 12 ist an Versorgungsleitung 6.4 und sein Ausgang 15 an die Versorgungsleitung 6.5 und somit an die Konstantspannungsversorgung angeschlossen. Der zwischen den Widerständen 13, 13.1 befindliche Knotenpunkt 16 ist an einen Datenübertragungskontakt 11.2 und zudem an die wandlerseitige Steuereinheit 10.2 angeschlossen.

Nicht dargestellt ist in dieser Figur eine Spannungsversorgung auf der Versorgungsleitung 6.4 mit einer gegenüber der nominalen Versorgungsspannung reduzierten Test- bzw. Detektionsspannung. Diese liegt auf der Versorgungsleitung 6.4 grundsätzlich an, damit der Wandler 3.2 zur Vornahme der gewünschten Verbrauchermoduldetektion betriebsbereit ist.

Das Verbrauchermodul 5.2 dieses elektrischen Versorgungssystems 1.2 verfügt ebenfalls über einen Spannungsteiler 17 mit zwei in Reihe geschalteten Widerständen 18, 18.1. Der verbrauchermodulseitige Spannungsteiler 17 ist mit seinem Eingang 19 und mit seinem Ausgang 20 an seine Spannungsversorgungskontakte 7.10, 7.11 bzw. an die daran angeschlossenen Leitungen angeschlossen. Ein zwischen den Widerständen 18, 18.1 befindlicher Knotenpunkt 21 ist an den dem Verbrauchermodul 5.2 zugeordneten Datenübertragungskontakt 11.3 angeschlossen. Der wandlungsseitige Spannungsteiler 12 weist ein anderes Teilerverhältnis auf als der verbrauchermodulseitige Spannungsteiler 17. Ist das Verbrauchermodul 5.2 an die Schnittstelle 2.2 des Wandlers 3.2 angeschlossen, wird bei Anliegen der Testspannung auf den Versorgungsleitungen 6.4, 6.5 die in dem wandlerseitigen Knotenpunkt 16 abgreifbare Spannung durch den Anschluss des Knotenpunktes 21 des verbrauchermodulseitigen Spannungsteilers 17 über die miteinander verbundenen Datenübertragungskontakte 11.2, 11.3 beeinflusst.

Zudem weist das elektrische Versorgungssystem 1.2 gemäß Figur 3 zumindest einen Widerstand 22 zwischen den Knotenpunkten 16, 21 der wandler- oder verbrauchermodulseitigen Spannungsteiler 12, 17 auf. Hierdurch wird der am Knotenpunkt 16 zur Verfügung gestellte Strom begrenzt und die Energieentnahme auf ein sicheres Maß limitiert.

Das Verbrauchermodul 5.2 verfügt als Verbraucher 4.2 über mehrere LEDs.

Zur Detektion, ob ein zulässiges Verbrauchermodul 5.2 bestimmungsgemäß an den Wandler 3.2 angeschlossen ist, vergleicht die Steuereinheit 10.2 den von dem als Spannungsteiler 12 eingesetzten Sensor breitgestellten Spannungs-Messwert mit einem Soll-Wertebereich. Bei dem dargestellten Ausführungsbeispiel liegt der Soll-Wertebereich zwischen 5,0V und 6,2V. Der wandlerseitige Spannungsteiler 12 ist ausgelegt, damit an seinem Kontenpunkt 16, wenn kein die Spannung im Knotenpunkt 16 beeinflussendes verbrauchermodulseitiges Gegenstück an die Schnittstelle 2.2 angeschlossen ist, eine Spannung von 7,8V abgreifbar ist. Ist ein zulässiges Verbrauchermodul, etwa das Verbrauchermodul 5.2, an die Schnittstelle 2.2 des Wandlers 3.2 angeschlossen, wird durch den verbrauchermodulseitigen Spannungsteiler 17, dessen Knotenpunkt 21 dann auf den wandlerseitigen Knotenpunkt 16 gelegt ist, die an dem Knotenpunkt 16 abgreifbare Spannung auf 5,6V reduziert. Um Messungenauigkeiten oder überlagernde Effekte zu vermeiden, ist bei diesem Ausführungsbeispiel der vorbeschriebene Soll-Wertebereich als Vergleichsgröße definiert worden.

Das Verfahren zum Detektieren des Anschlusses eines zulässigen Verbrauchermoduls an den Wandler 3.2 wird bei diesem Ausführungsbeispiel zum Verifizieren einer solchen Spannungsmessung wie folgt durchgeführt:
(i) Ein Zähler als Teil der Steuereinheit 10.2 wird nach Einschalten der Testspannung auf "0" gesetzt.
(ii) Wird zum Zeitpunkt der Messung an dem Knotenpunkt 16 nach vorherigem Anschließen des Verbrauchermoduls 5.2 an den Wandler 3.2 eine innerhalb des Soll-Bereiches liegende Spannung (5,0V - 6,2V) abgegriffen, wird dieses durch die Steuereinheit 10.2 interpretiert, dass das angeschlossene Verbrauchermodul 5.2 ein zulässiges ist. Der Zähler wird in einem solchen Fall um einen Zähler erhöht.
(iii) Diese Messung wird mehrfach, im vorliegenden Fall viermal mit kurzem Zeitabstand durchgeführt. Der Zähler wird jeweils um den Wert "1" erhöht, wenn eine nachfolgende Messung zu demselben Ergebnis führt.
(iv) Haben vier aufeinanderfolgende Messungen dasselbe Ergebnis geliefert, und zwar dass die erfasste Spannung innerhalb des Soll-Wertebereiches liegt, wird das in die Versorgungsleitung 6.4 eingeschaltete Schaltelement 8.2 geschlossen, womit die Versorgungsspannung zum Bestromen des Verbrauchermoduls 5.2 durchgeschaltet ist.
(v) Um sicherzustellen, dass das Durchschalten gemäß Schritt (iv) erst nach vier aufeinanderfolgenden gleichartigen Detektionen erfolgt, ist vorgesehen, dass bei einer erfassten Spannung, die nicht im Soll-Wertebereich liegt, der Zähler auf "0" zurückgesetzt wird.

Die zu dem Ausführungsbeispiel der Figur 3 beschriebene Kodierung des Verbrauchermoduls 1.2 bezüglich des Wandlers 3.2 ist sehr kostengünstig realisierbar. In vielen Fällen wird ein solcher Wandler ohnehin über eine Steuereinheit (Microcontroller) verfügen. Auch ist eine solche Kodierung gegenüber Missbrauch sehr unempfindlich. Die vorbeschriebene Verwendung von Spannungsteilern führt zu einer spezifischen elektrischen Kodierung, die sich von regulären Lastsituationen deutlich unterscheidet.

Bei diesem Ausführungsbeispiel kann vorgesehen sein, dass der Wandler 3.2 über eine Erkennungssensorik verfügt, über die erkannt wird, wann ein Verbrauchermodul 5.2 an die Schnittstelle 2.2 angeschlossen ist. Bei einer solchen Ausgestaltung wird nach Erkennen des Anschlusses eines Verbrauchermoduls, etwa des Verbrauchermoduls 5.2, an die Schnittstelle 2.2 des Wandlers 3.2 die Testspannung auf die Versorgungsleitungen 6.4, 6.5 gelegt. Dieses kann - wie in Figur 3 gezeigt - beispielsweise durch einen Bypass 23, durch den das in eine Versorgungsleitung 6.4 eingeschaltete Schaltelement 8.2 überbrückt wird, realisiert sein. Die Testspannung ist gegenüber der Versorgungsspannung geringer ausgelegt, in jedem Fall jedoch ist die Testspannung nur von extrem geringer Belastbarkeit geprägt, sodass keine gefährlichen Zustände durch sie entstehen können. Zur Erzeugung einer bezüglich der Versorgungsspannung geringeren Testspannung, die an dem Spannungsteiler 17 anliegt, ist in den Bypass 23 ein hochohmiger Widerstand 24 oder eine Strombegrenzung und ein durch die Steuereinheit 10.2 des Wandlers 3.2 ansteuerbares Schaltelement 25 eingeschaltet. Hierdurch wird für die Durchführung der Zulässigkeitsprüfung die durch die Spannungsversorgung S.2 bereitgestellte Spannung durch den hochohmigen Widerstand 24 erheblich reduziert, sodass die Testspannung sowohl für das Verbrauchermodul 5.2 als auch für eine unter Umständen an die Spannungsversorgungskontakte 7.8, 7.9 gelangende Person oder eingeführte Materialien unkritisch ist. Die Detektion eines zulässigen Verbrauchermoduls ist auch hier, wie zuvor beschrieben über die Spannungsänderung durch das Einwirken des Spannungsteilers 17 am Knotenpunkt 16 zu erfassen.

Auch bei dem Ausführungsbeispiel der Figur 3 verfügt das Verbrauchermodul 5.2 über eine Steuereinheit, die an den verbrauchermodulseitigen Datenübertragungskontakt 11.3 angeschlossen ist. Der Übersicht halber ist diese Steuereinheit in der Figur nicht gezeigt. Diese Steuereinheit dient zum Ansteuern des elektrischen Verbrauchers 4.2. Bei diesem Ausführungsbeispiel wird die über die Datenübertragungskontakte 11.2, 11.3 bereitgestellte Datenverbindung zwischen dem Wandler 3.2 und dem Verbrauchermodul 5.2 auch zum Übertragen von Daten bei einem Betrieb des Verbrauchermoduls 5.2 genutzt.

Das elektrische Versorgungssystem 1.2 kann auch so betrieben werden, dass über die beschriebene Datenverbindung von dem Verbrauchermodul 5.2 an den Wandler 3.2 bzw. seine Steuereinheit 10.2 ein Erkennungscode übertragen wird. In einem solchen Fall stellt die Steuereinheit 10.2 den Detektionssensor dar, wenn die zu dem Ausführungsbeispiel der Figur 3 beschriebenen Spannungsteiler 12, 17 nicht vorhanden sind bzw. nicht für die Verbrauchermodulcodierung eingesetzt werden.

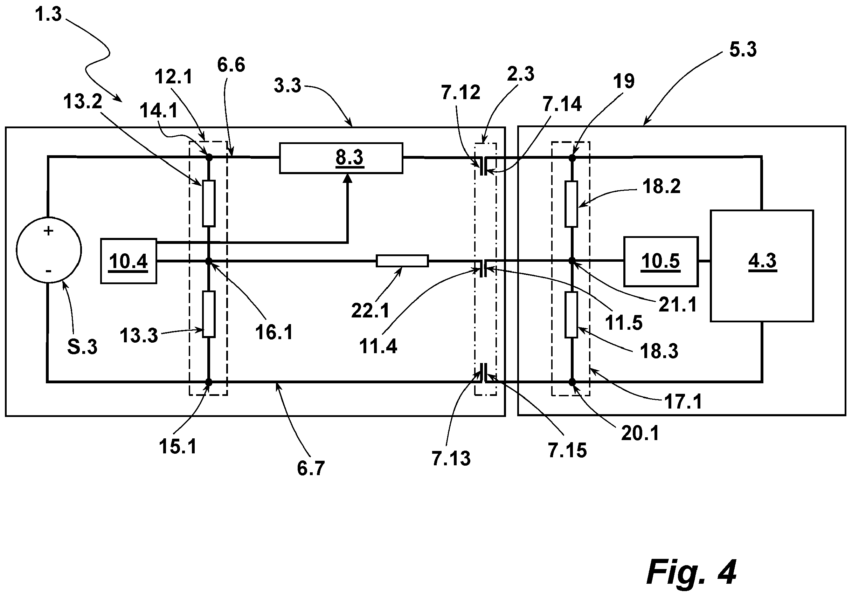

Figur 4 zeigt ein weiteres Ausführungsbeispiel eines elektrischen Versorgungssystems 1.3. Dieses ist vom Prinzip her ähnlich aufgebaut wie das zu Figur 3 beschriebene elektrische Versorgungssystem 1.2. Im Unterschied zu dem elektrischen Versorgungssystem 1.2 befindet sich bei dem elektrischen Versorgungssystem 1.3 der wandlerseitige Spannungsteiler 12.1 aufgespannt zwischen den elektrischen Versorgungsleitungen 6.6, 6.7 vor dem in die Versorgungsleitung 6.6 eingeschalteten Schaltelement 8.3. Auch bei diesem Ausführungsbeispiel sind gleiche Bauteile wie in den vorangegangenen Ausführungsbeispielen mit gleichen Bezugszeichen versehen, ergänzt um einen Suffix, der um einen Zähler größer ist als bei dem vorherigen Ausführungsbeispiel. Bei dem elektrischen Versorgungssystem 1.3 kann über den Datenübertragungskontakt 11.4 nur ein geringer Teststrom geführt werden, wenn das Schaltelement 8.3 geöffnet ist. Zu diesem Zweck ist der Datenübertragungskontakt 11.1 über eine Leitung an die elektrische Versorgungsleitung 6.6 angeschlossen. In diese Leitung ist der hochohmige Widerstand 22.1 eingeschaltet, damit über den Datenübertragungskontakt 11.4 nur ein geringer Strom fließen kann. Wird der wandlerseitige Datenübertragungskontakt 11.4 mit dem an die andere elektrische Versorgungsleitung 6.7 angeschlossenen Datenübertragungskontakt 7.13 elektrisch verbunden, kann die Steuereinheit 10.4 aufgrund ihres Anschlusses an den Knotenpunkt 16.1 und dessen Verbindung zur Masseleitung - der elektrischen Versorgungsleitung 6.7 - eine Spannung erfassen. Um dieses zu ermöglichen, ist es nicht unbedingt erforderlich, dass in den die elektrische Versorgungsleitung 6.7 mit dem Knotenpunkt 16.1 verbindenden Leitungsast der Widerstand 13.3 eingeschaltet ist.

Für die Zwecke einer Detektion des Verbrauchermoduls 5.3 wird grundsätzlich nur der Widerstand 18.3 seines Spannungsteilers 17.1 benötigt. Schließlich liegt an dem wandlerseitigen Spannungsversorgungskontakt 7.12 aufgrund des geöffneten Schaltelements 8.3 keine Spannung an. Ist das Verbrauchermodul 5.3 an den Wandler 3.3 angeschlossen, wird eine elektrische Verbindung zwischen dem wandlerseitigen Datenübertragungskontakt 11.4 und seinem Spannungsversorgungskontakt 7.13 über den Widerstand 18.3 hergestellt. Der Widerstand 18.3 bedingt einen Spannungsabfall, sodass die Steuereinheit 10.4 nach Anschließen des Verbrauchermoduls 5.3 an dem Wandler 3.3 einen Spannungsabfall gegenüber der am Datenübertragungskontakt 11.4 ansonsten anliegenden Spannung erfasst. Die Höhe des Spannungsabfalls bzw. die aufgrund des Widerstandes 18.3 von der Steuereinheit 10.4 gemessene Spannung dient als Kodierung für das Verbrauchermodul 5.3. Entspricht die durch die Steuereinheit 10.4 erfasste Spannung der vordefinierten Spannung, steuert die Steuereinheit 10.4 das Schaltelement 8.3 zum Schließen desselben an.

Da bei dem elektrischen Versorgungssystem 1.3 sowohl der Wandler 3.3 als auch das elektrische Verbrauchermodul 5.3 jeweils über einen Spannungsteiler 12.1 bzw. 17.1 verfügen, kann bei dieser Ausgestaltung eine zweite Kontrolle über die Spannungsteiler 12.1, 17.1 erfolgen, und zwar in analoger Weise, wie dieses zu dem Ausführungsbeispiel der Figur 3 beschrieben ist. Auf diese Weise kann eine redundante Kontrolle des an den Wandler 3.3 angeschlossenen Verbrauchermoduls 5.3 vorgenommen werden.

Ohne den Umfang der geltenden Ansprüche zu verlassen, ergeben sich für einen Fachmann daher zahlreiche weitere Möglichkeiten, den Gegenstand der Erfindung umzusetzen, ohne dass dieses im Rahmen dieser Ausführungen näher erläutert werden müsste.

### Bezugszeichenliste

- 1, 1.1 - 1.3: elektrisches Versorgungssystem
- 2, 2.1 - 2.3: Schnittstelle
- 3, 3.1 - 3.3: Wandler
- 4, 4.1 - 4.3: Verbraucher
- 5, 5.1 - 5.3: Verbrauchermodul
- 6, 6.1 - 6.7: Versorgungsleitung
- 7, 7.1 - 7.15: Spannungsversorgungskontakt
- 8, 8.1 - 8.3: Schaltelement
- 9, 9.1: Sensor
- 10, 10.1 - 10.5: Steuereinheit
- 11, 11.1 - 11.5: Datenübertragungskontakt
- 12, 12.1: Spannungsteiler
- 13, 13.1 - 13.3: Widerstand
- 14, 14.1: Eingang
- 15, 15.1: Ausgang
- 16, 16.1: Knotenpunkt
- 17, 17.1: Spannungsteiler
- 18, 18.1 - 18.3: Widerstand
- 19, 19.1: Eingang
- 20, 20.1: Ausgang
- 21, 21.1: Knotenpunkt
- 22,22.1: Widerstand
- 23: Bypass
- 24: Widerstand
- 25: Schaltelement

- S, S.1 - S.3: Spannungsversorgung

## Patentansprüche

1. Elektrisches Versorgungssystem mit einem eine mechanische und eine elektrische Schnittstelle (2, 2.1 - 2.3) aufweisenden Wandler (3, 3.1 - 3.3) mit einer Konstantspannungsversorgung (S, S.1 - S.3) und mit einem daran anschließbaren, zumindest einen elektrischen Verbraucher (4, 4.1 - 4.3) aufweisenden Verbrauchermodul (5, 5.1 - 5.3), wobei der Wandler (3, 3.1 - 3.3) und das Verbrauchermodul (5, 5.1 - 5.3) einen ersten und einen zweiten Spannungsversorgungkontakt (7 - 7.3; 7.4 - 7.7; 7.8 - 7.11; 7.12 - 7.15) umfassen, welche verbrauchermodulseitigen Spannungsversorgungskontakte (7.2, 7.3; 7.6, 7.7; 7.10, 7.11; 7.12 - 7.15) mit denjenigen des Wandlers (3, 3.1 - 3.3) lösbar verbindbar sind und welche wandlerseitigen Spannungsversorgungskontakte (7, 7.1; 7.4, 7.5; 7.8, 7.9; 7.12, 7.13) an eine Versorgungsleitung (6, 6.1; 6.2, 6.3; 6.4, 6.5; 6.6, 6.7) angeschlossen sind, **dadurch gekennzeichnet, dass** wandlerseitig in zumindest eine der beiden Versorgungsleitungen (6, 6.1; 6.2, 6.3; 6.4, 6.5; 6.6, 6.7) ein im nicht betätigten Zustand in Offen-Stellung befindliches Schaltelement (8, 8.1 - 8.3) eingeschaltet ist und der Wandler (3, 3.1 - 3.3) über einen Sensor (9, 9.1) zum Detektieren verfügt, ob ein für einen Betrieb mit diesem Wandler (3, 3.1 - 3.3) zulässiges Verbrauchermodul (5, 5.1 - 5.3) bestimmungsgemäß an seine Schnittstelle (2, 2.1 - 2.3) angeschlossen ist, wobei der Sensor (9, 9.1) bei einem bestimmungsgemäß an den Wandler (3, 3.1 - 3.3) angeschlossenen, zulässigen Verbrauchermodul (5, 5.1 - 5.3) mittel- oder unmittelbar das zumindest eine Schaltelement (8, 8.1 - 8.3) in seine Geschlossen-Stellung bringt.

2. Elektrisches Versorgungssystem nach Anspruch 1, **dadurch gekennzeichnet, dass** der Sensor (9) unmittelbar das Schaltelement (8) in seine Geschlossen-Stellung bringt.

3. Elektrisches Versorgungssystem nach Anspruch 1, **dadurch gekennzeichnet, dass** der Sensor (9.1) an eine Steuereinheit (10, 10.2, 10.4) angeschlossen ist und über diese das Schaltelement (8, 8.1 - 8.3) in seine Geschlossen-Stellung bringt.

4. Elektrisches Versorgungssystem nach Anspruch 3, **dadurch gekennzeichnet, dass** der Wandler (3.1, 3.2, 3.3) und das Verbrauchermodul (5.1, 5.2, 5.3) zusätzlich zu den jeweils zwei Spannungsversorgungkontakten (7.4 - 7.7; 7.8 - 7.11; 7.12 - 7.15) jeweils einen Datenübertragungskontakt (11, 11.1; 11.2, 11.3; 11.4, 11.5) aufweisen.

5. Elektrisches Versorgungssystem nach Anspruch 4, **dadurch gekennzeichnet, dass** von der ersten Versorgungsleitung (6.6) des Wandlers (3.3) - von der Spannungsquelle (S.3) aus betrachtet - vor dem Schaltelement (8.3) eine zumindest einen Widerstand (22.1) aufweisende Leitung zu dem Datenübertragungskontakt (11.4) abzweigt, und die Steuereinheit (10.4) an einem in dieser Leitung befindlichen Knotenpunkt (16.1) angeschlossen ist, wobei sich der Widerstand (22.1) zwischen dem Knotenpunkt (16.1) und dem Datenübertragungskontakt (11.4) befindet, und der Knotenpunkt (16.1) auch an die zweite elektrische Versorgungsleitung (6.7) angeschlossen ist, und dass das Verbrauchermodul (5.3) einen zwischen seinem Datenübertragungskontakt (11.5) und seinem an die zweite elektrische Versorgungsleitung (6.7) anzuschließenden Spannungsversorgungskontakt (7.15) aufgespannten Widerstand (18.3) zur Spannungskodierung des Verbrauchermoduls (5.3) aufweist.

6. Elektrisches Versorgungssystem nach Anspruch 4, **dadurch gekennzeichnet, dass** der Sensor einen Spannungsteiler (12, 12.1) mit zumindest zwei in Reihe geschalteten Widerständen (13, 13.1 - 13.3) umfasst, dessen Eingang (14, 14.1) an den ersten Spannungsversorgungkontakt (7.8, 7.12) und dessen Ausgang (15, 15.1) an den zweiten Spannungsversorgungkontakt (7.9, 7.13) angeschlossen sind und der Datenübertragungskontakt (11.2, 11.4) an einen zwischen den Widerständen (13, 13.1; 13.2, 13.3) befindlichen Knotenpunkt (16, 16.1) angeschlossenen ist, dass das Verbrauchermodul (5.2, 5.3) ebenfalls einen Spannungsteiler (17, 17.1) mit zumindest zwei in Reihe geschalteten Widerständen (18, 18.1; 18.2, 18.3) aufweist, dessen Eingang (19, 19.1) an den dem Eingang (14, 14.1) des wandlerseitigen Spannungsteilers (12, 12.1) zugeordneten Spannungsversorgungskontakt (7.10, 7.14) und sein Ausgang (20, 20.1) an den dem Ausgang (15, 15.1) des wandlerseitigen Spannungsteilers (12, 12.1) zugeordneten Spannungsversorgungskontakt (7.11, 7.15) angeschlossen sind, und der Datenübertragungskontakt (11.2, 11.4) an den zwischen den Widerständen (18, 18.1; 18-2, 18.3) befindlichen Knotenpunkt (21, 21.1) angeschlossen ist und dass die Steuereinheit (10.2, 10.4) die Spannung am Knotenpunkt (16, 16.1) des wandlerseitigen Spannungsteilers (17, 17.1) erfasst, mit einer Soll-Spannung oder Soll-Spannungsbereich vergleicht und die Konstantspannungsversorgung des Verbrauchermoduls (5.2, 5.3) freigibt, wenn die erfasste Ist-Spannung der durch die Soll-Spannung bzw. den Soll-Spannungsbereich definierten Zulässigkeitsbereich entspricht, wobei diese das Verbrauchermodul (5.2, 5.3) betreffende Zulässigkeitsprüfung mit einer gegenüber der Versorgungsspannung geringeren Testspannung durchgeführt wird.

7. Elektrisches Versorgungssystem nach Anspruch 6, **dadurch gekennzeichnet, dass** parallel zum Schaltelement (8.2) ein Bypass (23), durch den das Schaltelement (8.2) überbrückt ist, geschaltet ist, der einen hochohmigen Widerstand (24) oder eine Strombegrenzung und ein von der Steuereinheit (10.2) ansteuerbares Schaltelement (25) aufweist.

8. Elektrisches Versorgungssystem nach Anspruch 6 oder 7, **dadurch gekennzeichnet, dass** zwischen den Knotenpunkten (16, 21; 16.1, 21.1) des wandlerseitigen und des verbrauchermodulseitigen Spannungsteilers (12, 17; 12.1, 17.1) ein Widerstand (22, 22.1) angeordnet ist.

9. Elektrisches Versorgungssystem nach Anspruch 3 oder 4, **dadurch gekennzeichnet, dass** die Schnittstelle des Wandlers als physische Aufnahme ausgeführt ist, in die ein komplementäres, für einen Betrieb mit dem Wandler zulässiges Verbrauchermodul den Sensor betätigendes Gegenstück bestimmungsgemäß eingesetzt ist.

10. Elektrisches Versorgungssystem nach Anspruch 9, **dadurch gekennzeichnet, dass** der Sensor das in eine Versorgungsleitung eingeschaltete Schaltelement ist.

11. Elektrisches Versorgungssystem nach Anspruch 9 oder 10, **dadurch gekennzeichnet, dass** das dem Verbrauchermodul zugehörige Gegenstück den Sensor mechanisch betätigt.

12. Elektrisches Versorgungssystem nach Anspruch 9 oder 10, **dadurch gekennzeichnet, dass** das dem Verbrauchermodul zugehörige Gegenstück über einen Betätigungsmagneten und der Sensor über einen Auslösemagneten verfügt, welcher Betätigungsmagnet bei in die Aufnahme eingesetztem Gegenstück auf den Auslösemagnet zum Schließen des Schaltelementes wirkt.

13. Elektrisches Versorgungssystem nach Anspruch 12, **dadurch gekennzeichnet, dass** durch die Wirkverbindung von Betätigungsmagnet und Auslösemagnet das Verbrauchermodul an der wandlerseitigen Schnittstelle gehalten ist.

14. Verfahren zum Betreiben eines elektrischen Versorgungssystems (1, 1.1, 1,2) nach einem der Ansprüche 1 bis 13, **dadurch gekennzeichnet, dass** durch den Sensor (9, 9.1) des Wandlers (3, 3.1 - 3.3) detektiert wird, ob ein für einen Betrieb mit diesem Wandler (3, 3.1 - 3.3) zulässiges Verbrauchermodul (5, 5.1, 5.2, 5.3) bestimmungsgemäß an die Schnittstelle (2, 2.1 - 2.3) des Wandlers (3, 3.1 - 3.3) angeschlossen ist, und dass durch den Sensor (9, 9.1) mittel- oder unmittelbar das zumindest eine Schaltelement (8, 8.1 - 8.2) in seine Geschlossen-Stellung gebracht wird.

15. Verfahren nach Anspruch 14 in seinem Rückbezug auf Anspruch 3, **dadurch gekennzeichnet, dass** die Detektion, ob ein für einen Betrieb mit diesem Wandler (3.2, 3.3) zulässiges Verbrauchermodul (5.2, 5.3) bestimmungsgemäß an die Schnittstelle (2, 2.1) des Wandlers (3.2, 3.3) angeschlossen ist, durch die Steuereinheit (10.2, 10.4) mehrfach durchgeführt wird und das Schaltelement (8.2, 8.3) zur Beaufschlagung des Verbrauchermoduls (5.2, 5.3) mit der Versorgungsspannung erst nach Erreichen einer gewissen Anzahl von gleichartigen Detektionsergebnissen geschlossen wird.
